# EUROPÄISCHE PATENTSCHRIFT

(11) **EP 4 538 877 B1**
(45) Veröffentlichungstag und Bekanntmachung des Hinweises auf die Patenterteilung: **08.04.2026**
(21) Anmeldenummer: 24198573.8
(22) Anmeldetag: 05.09.2024
(51) Int. Cl.: G06F 30/20, G06F 30/33, G06F 9/455

(54) **VERFAHREN ZUM AUSFÜHREN EINER SIMULATION AUF EINEM REALEN PROZESSOR**
METHOD FOR CARRYING OUT A SIMULATION ON A REAL PROCESSOR
PROCÉDÉ D'EXÉCUTION D'UNE SIMULATION SUR UN PROCESSEUR RÉEL

(30) Priorität: 12.10.2023 DE 102023127837
(43) Veröffentlichungstag der Anmeldung: 16.04.2025
(73) Patentinhaber: dSPACE SE & Co. KG, 33102 Paderborn (DE)
(72) Erfinder: Sielhorst, Dr. Tobias, 33102 Paderborn (DE)

(56) Entgegenhaltungen:
- ANONYMOUS: "Virtualization - Wikipedia", 18 October 2018 (2018-10-18), pages 1 - 8, XP093015526, Retrieved from the Internet <URL:https://en.wikipedia.org/w/index.php?title=Virtualization&oldid=864616919> [retrieved on 20230119]
- ANONYMOUS -WIKIPEDIA ET AL: "QEMU - Wikipedia", 29 September 2023 (2023-09-29), pages 1 - 14, XP093248347, Retrieved from the Internet <URL:https://en.wikipedia.org/w/index.php?title=QEMU&oldid=1177792646> [retrieved on 20250210]
- ANONYMOUS: "QEMU - ArchWiki", 4 October 2023 (2023-10-04), pages 1 - 61, XP093248501, Retrieved from the Internet <URL:https://wiki.archlinux.org/index.php?title=QEMU&oldid=789262> [retrieved on 20250210]
- YANG ANNA ET AL: "A Method for Reducing Simulation Timing Deviation in QEMU-Based Virtual ECU", 2023 14TH INTERNATIONAL CONFERENCE ON INFORMATION AND COMMUNICATION TECHNOLOGY CONVERGENCE (ICTC), IEEE, 11 October 2023 (2023-10-11), pages 265 - 270, XP034523997, DOI: 10.1109/ICTC58733.2023.10393554
- YANG ANNA ET AL: "An I/O Simulation Method for AUTOSAR-Based Operation Verification in an QEMU-Based Virtual ECU", 2023 14TH INTERNATIONAL CONFERENCE ON INFORMATION AND COMMUNICATION TECHNOLOGY CONVERGENCE (ICTC), IEEE, 11 October 2023 (2023-10-11), pages 271 - 276, XP034524165, DOI: 10.1109/ICTC58733.2023.10393754

## Beschreibung

Die Erfindung betrifft ein Verfahren zum Ausführen einer Simulation auf einem realen Prozessor eines ersten Prozessortyps, wobei die Simulation wenigstens ein Simulationsmodell aufweist, das für den ersten Prozessortyp kompiliert ist.

Ein virtuelles Steuergerät, eine sogenannte V-ECU, ist eine Software, die in einem Simulationsszenario ein echtes Steuergerät oder einen Teil eines echten Steuergeräts simuliert. Verschiedene V-ECU-Versionen decken einen großen Variantenbereich ab - von sehr einfachen Versionen bis hin zu einer Komplettversion, die alle Komponenten eines realen Steuergeräts enthält: In einer vereinfachten Modellierung beinhaltet eine V-ECU beispielsweise nur eine einzige Applikationssoftwarekomponente und die unterschiedlichen darunterliegenden Schichten des Betriebssystems und der Treiber werden abstrahiert. In einer komplexeren Version enthält die V-ECU mehrere verknüpfte Software-Komponenten, zum Beispiel die komplette Funktionalität eines Steuergeräts. Im Bereich Automotive gehört z.B. auch die AUTOSAR Runtime Environment (RTE) und das Betriebssystem für realistisches Task Scheduling dazu. Bei Bedarf können ausgewählte Software-Komponenten hinzugefügt werden, um die Buskommunikation oder den NVRAM zu simulieren. Eine V-ECU wird noch realistischer, wenn der echte Basis-Software-Code hinzugefügt wird, der auch im Seriencode verwendet wird. Eine V-ECU enthält somit Komponenten von Applikations- und Basis-Software und bietet daher Funktionalitäten, die mit denen echter Steuergeräte vergleichbar sind. Eingesetzt wird sie z.B. für die Validierung während einer Computer-basierten Simulation.

Da beim Einsatz einer V-ECU nicht mit realer Steuergeräte-Hardware gearbeitet wird, kann die Simulation schneller als in Echtzeit erfolgen, so dass die Analyse des simulierten Steuergeräts sehr zeitsparend und komfortabel erfolgen kann. Durch Software-in-the-Loop-Test (SIL-Tests) in Computer-basierten Simulationen können Software-Funktionen, V-ECUs oder komplette V-ECU-Netzwerke simuliert und getestet werden.

Der Software-Entwicklungsprozess für klassische Automobilanwendungen, wie Antriebsstrang- oder Bremssystemen, bis hin zu E-Drive-Anwendungen und Funktionen für das autonome Fahren kann mittels SIL-Tests durch virtuelles Testen und Validieren deutlich beschleunigt werden. So kann ein DUT (device under test) komfortabel auf einem Computer simuliert werden, es kann mit physikalisch basierten Modellen verbunden werden und Testskripte können später auf Hardware-in-the-Loop (HIL)-Systemen einfach wiederverwendet werden.

Für SIL-Tests werden in der Regel aufwendige Simulationssysteme erstellt. Die Modelle für ein solches Simulationssystem können kompiliert im Binärformat vorliegen oder auch als zu kompilierender Code. Gerade im Bereich der Softwareabsicherung kann die Software in beiden Varianten vorkommen. Im ersten Fall sind die Modelle prozessor- und betriebssystemspezifisch. Im zweiten Fall sind die Modelle im Allgemeinen in dieser Hinsicht flexibler, aber diese Art der Bereitstellung ist aus unterschiedlichen Gründen nicht immer verfügbar. Auf einem Emulator kann man beliebigen Prozessorcode emulieren, wenn ein entsprechendes Prozessormodell vorliegt. Die Emulation ist jedoch deutlich langsamer als eine native Ausführung von Befehlen auf dem Zielprozessor. Wenn der Binärcode für den Prozessor kompiliert ist, kann man die Software auf einer virtuellen Maschine ausführen. Wenn der Binärcode für den Prozessor und das Betriebssystem des Simulators kompiliert ist, kann er auch ohne Virtualisierung direkt auf dem Rechner ausgeführt werden.

Die Wikipedia-Seite "Virtualization" (https://en.wikipedia.org/wiki/Virtualization) beschreibt die Schaffung einer virtuellen Version von Hardwareplattformen, Speichergeräten oder Netzwerkressourcen. Sie erklärt, dass Virtualisierung es ermöglicht, mehrere Betriebssysteme gleichzeitig auf einem physischen System auszuführen. Dabei kommen Hypervisoren oder Virtual Machine Monitors (VMM) zum Einsatz, die als Vermittler zwischen der Hardware und den virtuellen Maschinen fungieren. Es werden verschiedene Typen von Virtualisierung (z. B. Hardware-, Speicher- und Netzwerkvirtualisierung) erläutert sowie Vorteile wie bessere Ressourcenausnutzung und Flexibilität. Historische Entwicklungen, Anwendungsbeispiele und Sicherheitsaspekte werden ebenfalls kurz behandelt.

Die Wikipedia-Seite "QEMU" (https:I/en.wikipedia.org/wiki/QEMU) beschreibt, dass QEMU ein freier und quelloffener Emulator und Virtualisierer ist. Er ermöglicht die Ausführung von Programmen und ganzen Betriebssystemen für eine CPU-Architektur auf einer anderen, z. B. ARM auf x86. QEMU unterstützt sowohl Systememulation (komplette Maschinen) als auch Benutzermodus-Emulation (einzelne Programme). In Kombination mit KVM auf Linux kann QEMU auch hardwareunterstützte Virtualisierung mit nahezu nativer Geschwindigkeit leisten. Es wird oft für Entwicklung, Test und Betrieb virtueller Maschinen verwendet. QEMU ist plattformübergreifend einsetzbar, unterstützt Snapshots, Geräteemulation, Netzwerk- und Speicheremulation und wird aktiv weiterentwickelt.

Die ArchWiki-Seite "QEMU" (https://wiki.archlinux.org/title/QEMU) bietet eine Anleitung zur Installation und Nutzung von QEMU unter Arch Linux. QEMU ist ein freier Emulator und Virtualisierer, der verschiedene Architekturen unterstützt. Die Seite beschreibt die Einrichtung von QEMU mit oder ohne KVM (für Hardware-Virtualisierung), die Konfiguration virtueller Maschinen (inklusive Netzwerk, Laufwerken und Grafikausgabe) sowie Tipps zur Performance-Optimierung. Zudem werden fortgeschrittene Szenarien wie die Verwendung von UEFI, PCI-Passthrough und die Integration mit virt-manager behandelt. Zahlreiche Befehlsbeispiele und Links zu verwandten Tools runden den praxisnahen Leitfaden ab. Die Seite richtet sich an fortgeschrittene Linux-Nutzer.

Es ist die Aufgabe der Erfindung, eine große Flexibilität bei der Auswahl der Modelle aber auch bei der Auswahl der Zielplattform der Simulation bereitzustellen und dabei auf effiziente Weise eine lauffähige Konfiguration zu erreichen.

Diese Aufgabe wird durch den Gegenstand des Patentanspruchs 1 gelöst. Bevorzugte Weiterbildungen finden sich in den Unteransprüchen.

Erfindungsgemäß wird somit ein Verfahren zum Ausführen einer Simulation auf einem realen Prozessor eines ersten Prozessortyps bereitgestellt, wobei die Simulation wenigstens ein Simulationsmodell aufweist, das für den ersten Prozessortyp kompiliert ist, mit dem folgenden Verfahrensschritt:
Ausführen des für den ersten Prozessortyp kompilierten Simulationsmodells auf dem realen Prozessor des ersten Prozessortyps als Emulation des Prozessors des ersten Prozessortyps,
dadurch gekennzeichnet, dass das Ausführen eines für einen bestimmten Prozessortyp kompilierten Simulationsmodells auf einem emulierten Prozessor des entsprechenden Prozessortyps dadurch erzielt wird, dass ein Simulationslauf mit einer auf dem Prozessor vorhandenen Emulation für einen der verfügbaren Prozessortypen gestartet wird und, falls dieser Simulationslauf nicht erfolgreich abgeschlossen werden kann, so lange auf einen Simulationslauf mit einer Emulation für einen anderen Prozessortyp gewechselt wird, bis ein Simulationslauf erfolgreich abgeschlossen worden ist.

Es ist somit ein wesentlicher Aspekt der Erfindung, dass die Simulation zunächst für alle Modelle eine Prozessoremulation vorsieht, insbesondere also auch für ein Simulationsmodell, das für den Prozessortyp des realen Prozessors kompiliert ist. Das entspricht nicht der herkömmlichen Vorgehensweise, weil man z.B. bei einer SIL-Simulation normalerweise Code passend zum SIL-Simulator kompiliert. Die Erfindung nimmt aber bewusst in Kauf, dass das oben beschriebene Verfahren den SIL-Simulator etwas aufwendiger macht. Der erfindungsgemäße Vorteil liegt dann aber in einer sehr großen Flexibilität sowohl bei der Auswahl der Modelle als auch bei der Auswahl der Zielplattform der Simulation. Ein Nutzer des erfindungsgemäßen Verfahrens kann sich also z.B. für eine bestimmte Zielarchitektur des Simulators in einer Cloud-Anwendung entscheiden, wenn diese am besten zu seinen Anforderungen passt, ohne sonstige Kompatibilitäten berücksichtigen zu müssen. Die zumindest anfängliche Ausführung der Modelle in einer Emulation stellt sicher, dass die Simulation korrekt durchführbar ist, selbst wenn es für die Ausführungsgeschwindigkeit nicht optimal ist.

Im Übrigen können auf diese Weise die Binaries im Emulator auf unterschiedlichen Prozessormodellen gestartet werden, so dass der Prozessortypen mit Hilfe von fehlerfreien Simulationsläufen ermittelt werden kann. Die Erfindung gibt schließlich vor, dass anfänglich alle Modelle mit einem Emulator durchgeführt werden. Dadurch können alle Zielsysteme simuliert werden, für die ein Prozessormodell vorhanden ist. Ob das Prozessormodell tatsächlich vorhanden ist, kann auf diese Weise leicht herausgefunden werden. Dies entbindet einen Nutzer des Verfahrens von Konfigurationstätigkeiten. Während bei herkömmlichen Verfahren das Prozessormodell durch den Simulator implizit vorgegeben war, ist es nun möglich, auf einfache und sichere Weise eine vorhandene Kompatibilität zu ermitteln, insbesondere falls diese nicht explizit genannt oder erhältlich ist.

Gemäß einer bevorzugten Weiterbildung ist nun vorgesehen, dass die Simulation wenigstens ein Simulationsmodell aufweist, das für einen von dem ersten Prozessortyp verschiedenen zweiten Prozessortyp kompiliert ist, mit dem folgenden Verfahrensschritt:
Ausführen des für den zweiten Prozessortyp kompilierten Simulationsmodells auf dem realen Prozessor des ersten Prozessortyps als Emulation des Prozessors des zweiten Prozessortyps.

Diese Ausgestaltung der Erfindung trägt der Situation Rechnung, dass die Simulation wenigstens ein Simulationsmodell aufweisen kann, das für einen von dem ersten Prozessortyp verschiedenen zweiten Prozessortyp kompiliert ist, und in diesem Fall ein Emulieren eines Prozessors des zweiten Prozessortyps auf dem realen Prozessor erfolgen muss, um ein Ausführen des für den zweiten Prozessortyp kompilierten Simulationsmodells auf realen Prozessor zu ermöglichen. Während hier also das Ausführen des Simulationsmodells zwingend ein Emulieren eines Prozessors des Prozessortyps, für den das Simulationsmodell kompiliert ist, auf dem realen Prozessor erfordert, wäre das bei der eingangs geschilderten Situation nicht der Fall. Dort weist die Simulation ein Simulationsmodell auf, das für den ersten Prozessortyp kompiliert ist, so dass eigentlich keine Emulation erforderlich wäre. Das bedeutet mit anderen Worten, dass erfindungsgemäß unabhängig davon, für welchen Prozessortyp ein Simulationsmodell kompiliert ist, zumindest anfänglich, immer eine Emulation des entsprechenden Prozessortyps auf dem realen Prozessor erfolgt, selbst wenn der emulierte Prozessortyp mit dem Prozessortyp des realen Prozessors übereinstimmt. Um das Verfahren besonders effizient zu machen, wird dabei vorzugsweise, zumindest anfänglich, überhaupt nicht geprüft, oder der Prozessortyp, für den das Simulationsmodell kompiliert ist, mit dem Prozessortyp des realen Prozessors übereinstimmt.

Wenn vorliegend von einer zumindest anfänglichen Ausführung der Modelle in einer Emulation gesprochen wird und wenn es vorliegend heißt, dass zumindest anfänglich, immer eine Emulation des entsprechenden Prozessortyps auf dem realen Prozessor erfolgt, selbst wenn der emulierte Prozessortyp mit dem Prozessortyp des realen Prozessors übereinstimmt, und dass vorzugsweise, zumindest anfänglich, überhaupt nicht geprüft wird, ob der Prozessortype, für den das Simulationsmodell kompiliert ist, mit dem Prozessortyp des realen Prozessors übereinstimmt, so ist damit gemeint, dass dies am Anfang des Verfahrens gilt, also wenigstens für einen ersten Simulationslauf. Wie weiter unten dargestellt, ist es mitunter jedoch möglich, bei nachfolgenden Simulationsläufen, auf die in Rede stehende Emulation zu verzichten.

Unter diesem Aspekt ist es gemäß einer bevorzugten Weiterbildung der Erfindung vorgesehen, dass nach dem Ausführen des für den ersten Prozessortyp kompilierten Simulationsmodells auf dem Prozessor des ersten Prozessortyps als Emulation desselben, die folgenden Schritte durchgeführt werden:
Ausführen solcher Simulationsmodelle der Simulation auf einer virtuellen Maschine des realen Prozessors, die für den Prozessortyp des realen Prozessors, nicht aber für das Betriebssystem realen Prozessors kompiliert sind, sowie
Ausführen solcher Simulationsmodelle der Simulation auf dem realen Prozessor ohne Emulation, die für den Prozessortyp des realen Prozessors sowie für das Betriebssystem realen Prozessors kompiliert sind.

Bei dieser bevorzugten Ausgestaltung der Erfindung wird also die vorhandene Hardware besser genutzt, ohne dass das Simulationssystem geändert werden müsste. Im Ergebnis können damit zwei Anwendungsfälle auf einfache Weise bedient werden, nämlich eine skalierbare Nutzung allgemeiner Hardware und eine effiziente Ausnutzung spezieller Hardware. Insbesondere kann außerhalb von Cloud-Anwendungen die gleiche Simulation wie gewohnt als kompilierte Datei direkt auf einem Rechner laufen und so Debugging-Anforderungen ohne zusätzliche Hindernisse erfüllen.

Ferner ist gemäß einer bevorzugten Weiterbildung der Erfindung vorgesehen, dass die Simulation ermittelt, welches Simulationsmodell für die Ausführung am meisten Zeit erfordert, und ermittelt, für welchen Prozessortyp dieses Simulationsmodell kompiliert ist. In diesem Zusammenhang gilt dabei vorzugsweise, dass für das weitere Verfahren nachfolgend automatisch auf den ermittelten Prozessortyp gewechselt wird.

Auf diese Weise kann die beste Hardware bezüglich der Modelle vorgeschlagen werden. Dabei können die Modelle auch unbekannte Binaries enthalten, wie zuvor beschrieben. Durch die Simulation kann der Simulator herausfinden, welches Modell den Flaschenhals in der Berechnung darstellt und ob für dieses Modell gerade eine Emulierung durchgeführt wird und somit ohne eine solche Emulierung eine schnellere Ausführung möglich wäre.

Nachfolgend wird die Erfindung anhand eines bevorzugten Ausführungsbeispiels unter Bezugnahme auf die Zeichnung weiter im Detail erläutert.

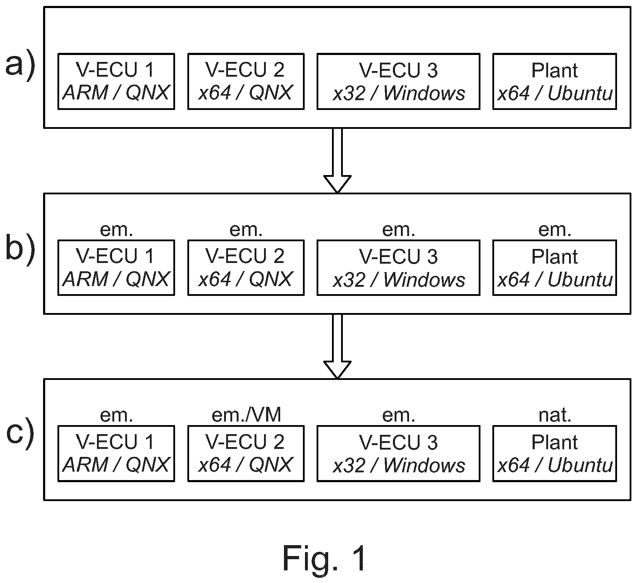

In der Zeichnung zeigt
Fig. 1 schematisch ein Verfahren gemäß einem bevorzugten Ausführungsbeispiel der Erfindung.

Gemäß dem in Fig. 1 dargestellten bevorzugten Ausführungsbeispiel der Erfindung ist ein Gesamtsystem vorgesehen, das vier verschiedene Simulationsmodelle aufweist. Die Teilmodelle des Gesamtsystem sind für verschiedene Prozessortypen kompiliert. Dies ist in Fig. 1 unter a) schematisch dargestellt: Es sind drei V-ECU-Modelle vorgesehen, in Fig. 1 mit V-ECU 1, V-ECU 2 und V-ECU 3 bezeichnet, die kompiliert sind für ARM/QNX (Prozessormodell: ARM/ Betriebssystem: QNX), x64/QNX (Prozessormodell: x64/ Betriebssystem: QNX) bzw. x86/Windows (Prozessormodell: x86/ Betriebssystem: Windows). Darüber hinaus ist ein Plant-Modell vorgesehen, das kompiliert ist für x64/Ubuntu (Prozessormodell: x64/ Betriebssystem: Ubuntu).

Unter b) ist in Fig. 1 dargestellt, dass das Simulationssystem auf einem Simulator innerhalb eines x64/Ubuntu-Systems läuft, wobei gleichwohl im ersten Simulationslauf alle vier Modelle unter einer Emulation ihres jeweiligen Prozessormodells betrieben werden, wie durch die Kürzel "em." für alle vier Modelle gekennzeichnet. Dies ist die Verwirklichung des erfindungswesentlichen Merkmals, dass die Erfindung unabhängig davon, für welchen Prozessortyp ein Simulationsmodell kompiliert ist, zumindest anfänglich, immer eine Emulation des entsprechenden Prozessortyps auf dem realen Prozessor erfolgt, selbst wenn der emulierte Prozessortyp mit dem Prozessortyp des realen Prozessors übereinstimmt.

Nun ist es so, dass grundsätzlich alle Modelle in einer Emulation laufen müssen bis auf das Modell, das für x64/Ubuntu erstellt wurde, da das Simulationssystem auf einem Simulator innerhalb eines x64/Ubuntu-Systems läuft. Somit könnte das x64/Ubuntu-Modell effizienter direkt, also ohne Emulation, laufen. Um dies nach dem Anlaufen des Verfahrens, also nach dem ersten Simulationslauf, zu ermöglichen, wird vorliegend so vorgegangen, dass ein Simulationslauf mit einer auf dem Prozessor vorhandenen Emulation für einen der verfügbaren Prozessortypen gestartet wird und, falls dieser Simulationslauf nicht erfolgreich abgeschlossen werden kann, so lange auf einen Simulationslauf mit einer Emulation für einen anderen Prozessortyp gewechselt wird, bis ein Simulationslauf erfolgreich abgeschlossen worden ist, vorliegend also ermittelt worden ist, dass das Plant-Modell für 64/Ubuntu kompiliert worden ist. Das Plant-Modell kann damit vorliegend direkt (natürlich) auf dem realen Prozessor ohne Emulation laufen, was in Fig. 1 mit "nat." gekennzeichnet ist.

Eine Sonderstellung kommt dem Modell V-ECU 2 zu: Dieses ist zwar für den Prozessortyp des realen Prozessors, nicht aber für das Betriebssystem realen Prozessors kompiliert. Bei dieser Situation kann jedenfalls dadurch ein effizienterer Betrieb erzielt werden, dass dieses Modell unter einer Emulation auf einer virtuellen Maschine (VM) des realen Prozessors läuft, hier mit "em./VM" gekennzeichnet.

Gemäß einem bevorzugten Ausführungsbeispiel der Erfindung ist es auch möglich, dass der Simulator eine optimale Hardware bezüglich der Modelle vorschlägt. Die Modelle können dabei auch unbekannte Binaries enthalten, wie weiter oben beschrieben. Durch die Simulation kann der Simulator herausfinden, welches Modell den Flaschenhals in der Berechnung darstellt und ob dieses Modell nun emuliert wird oder nicht und somit ggf. schneller ausgeführt werden könnte.

Zum Beispiel ist das der Fall, wenn der Simulator erkennt, dass ein Simulationssystem aus 3 Modellen für einen ARM-Prozessor, 4 frei kompilierbaren Modellen und 5 Modellen für einen x64-Prozessor. Wird nun, wie zuvor beschrieben, festgestellt, dass die für den ARM-Prozessor kompilierten Modelle den rechnerischen Flaschenhals darstellen, aber die Simulation auf einem x64-System stattfindet, kann automatisiert eine Ausgabe erfolgen, dass die Verwendung einer ARM-Hardware in der Cloud effizienter wäre als die aktuell verwendete x64-Hardware.

Ein wesentlicher Vorteil der Erfindung besteht somit darin, dass durch die anfänglich immer stattfindende und somit standardmäßig vorgesehene Prozessoremulation der Modelle eine hardwareunabhängige Simulation ermöglicht ist, aber Hardware- und Betriebssystemvoraussetzungen ohne weitere Konfigurationen am Simulationsmodell genutzt werden können. Da ein Nutzer der Erfindung sich nicht von vorneherein entscheiden muss, ob er entweder eine hohe Flexibilität oder eine hohe Effizienz benötigt, können unterschiedliche Interessen des Nutzers gleichzeitig bedient werden.

## Patentansprüche

1. Verfahren zum Ausführen einer Simulation auf einem realen Prozessor eines ersten Prozessortyps, wobei die Simulation wenigstens ein Simulationsmodell aufweist, das für den ersten Prozessortyp kompiliert ist, mit dem folgenden Verfahrensschritt:
Ausführen des für den ersten Prozessortyp kompilierten Simulationsmodells auf dem realen Prozessor des ersten Prozessortyps als Emulation des Prozessors des ersten Prozessortyps,
**dadurch gekennzeichnet, dass** das Ausführen eines für einen bestimmten Prozessortyp kompilierten Simulationsmodells auf einem emulierten Prozessor des entsprechenden Prozessortyps dadurch erzielt wird, dass ein Simulationslauf mit einer auf dem Prozessor vorhandenen Emulation für einen der verfügbaren Prozessortypen gestartet wird und, falls dieser Simulationslauf nicht erfolgreich abgeschlossen werden kann, so lange auf einen Simulationslauf mit einer Emulation für einen anderen Prozessortyp gewechselt wird, bis ein Simulationslauf erfolgreich abgeschlossen worden ist.

2. Verfahren nach Anspruch 1, wobei die Simulation wenigstens ein Simulationsmodell aufweist, das für einen von dem ersten Prozessortyp verschiedenen zweiten Prozessortyp kompiliert ist, mit dem folgenden Verfahrensschritt:
Ausführen des für den zweiten Prozessortyp kompilierten Simulationsmodells auf dem realen Prozessor des ersten Prozessortyps als Emulation des Prozessors des zweiten Prozessortyps.

3. Verfahren nach Anspruch 1 oder 2, wobei nach dem Ausführen des für den ersten Prozessortyp kompilierten Simulationsmodells auf dem realen Prozessor des ersten Prozessortyps als Emulation des Prozessors des ersten Prozessortyps, die folgenden Schritte durchgeführt werden:
Ausführen solcher Simulationsmodelle der Simulation auf einer virtuellen Maschine des realen Prozessors, die für den Prozessortyp des realen Prozessors, nicht aber für das Betriebssystem realen Prozessors kompiliert sind, sowie
Ausführen solcher Simulationsmodelle der Simulation auf dem realen Prozessor ohne Emulation, die für den Prozessortyp des realen Prozessors sowie für das Betriebssystem realen Prozessors kompiliert sind.

4. Verfahren nach einem der vorhergehenden Ansprüche, wobei die Simulation ermittelt, welches Simulationsmodell für die Ausführung am meisten Zeit erfordert, und ermittelt, für welchen Prozessortyp dieses Simulationsmodell kompiliert ist.

5. Verfahren nach Anspruch 4, wobei für das weitere Verfahren nachfolgend automatisch auf den ermittelten Prozessortyp gewechselt wird.

## Claims

1. Method for executing a simulation on a real processor of a first processor type, wherein the simulation comprises at least one simulation model which is compiled for the first processor type, with the following method step:
executing the simulation model compiled for the first processor type on the real processor of the first processor type as emulation of the processor of the first processor type,
**characterised in that** the execution of a simulation model compiled for a specific processor type on an emulated processor of the corresponding processor type is achieved by starting a simulation run with an emulation present on the processor for one of the available processor types and, if this simulation run cannot be successfully completed, switching to a simulation run with an emulation for another processor type until a simulation run has been successfully completed.

2. Method according to claim 1, wherein the simulation comprises at least one simulation model which is compiled for a second processor type different from the first processor type, with the following method step:
executing the simulation model compiled for the second processor type on the real processor of the first processor type as emulation of the processor of the second processor type.

3. Method according to claim 1 or 2, wherein, after executing the simulation model compiled for the first processor type on the real processor of the first processor type as emulation of the processor of the first processor type, the following steps are performed:
executing such simulation models of the simulation on a virtual machine of the real processor, which are compiled for the processor type of the real processor but not for the operating system of the real processor, and
executing such simulation models of the simulation on the real processor without emulation, which are compiled for the processor type of the real processor and for the operating system of the real processor.

4. Method according to one of the preceding claims, wherein the simulation determines which simulation model requires the most time for execution, and determines for which processor type this simulation model is compiled.

5. Method according to claim 4, wherein for the further method subsequently the system automatically switches to the determined processor type.

## Revendications

1. Procédé d'exécution d'une simulation sur un processeur réel d'un premier type de processeur, la simulation comprenant au moins un modèle de simulation compilé pour le premier type de processeur, comprenant l'étape de procédé suivante :
Exécution du modèle de simulation compilé pour le premier type de processeur sur le processeur réel du premier type de processeur en tant qu'émulation du processeur du premier type de processeur,
**caractérisé en ce que** l'exécution d'un modèle de simulation compilé pour un certain type de processeur sur un processeur émulé du type de processeur correspondant est obtenue en démarrant une exécution de simulation avec une émulation présente sur le processeur pour l'un des types de processeurs disponibles et, si cette exécution de simulation ne peut pas être achevée avec succès, en passant à une exécution de simulation avec une émulation pour un autre type de processeur jusqu'à ce qu'une exécution de simulation ait été achevée avec succès.

2. Procédé selon la revendication 1, dans lequel la simulation comprend au moins un modèle de simulation compilé pour un deuxième type de processeur différent du premier type de processeur, comprenant l'étape de procédé suivante :
Exécution du modèle de simulation compilé pour le deuxième type de processeur sur le processeur réel du premier type de processeur en tant qu'émulation du processeur du deuxième type de processeur.

3. Procédé selon la revendication 1 ou 2, dans lequel, après l'exécution du modèle de simulation compilé pour le premier type de processeur sur le processeur réel du premier type de processeur en tant qu'émulation du processeur du premier type de processeur, les étapes suivantes sont exécutées :
exécuter de tels modèles de simulation de la simulation sur une machine virtuelle du processeur réel, qui sont compilés pour le type de processeur du processeur réel, mais pas pour le système d'exploitation du processeur réel, et
Exécution de tels modèles de simulation de la simulation sur le processeur réel sans émulation, qui sont compilés pour le type de processeur du processeur réel ainsi que pour le système d'exploitation du processeur réel.

4. Procédé selon l'une des revendications précédentes, dans lequel la simulation détermine quel modèle de simulation nécessite le plus de temps pour l'exécution et détermine pour quel type de processeur ce modèle de simulation est compilé.

5. Procédé selon la revendication 4, dans lequel, pour la suite du procédé, on passe automatiquement au type de processeur déterminé.
